(19) Europäisches Patentamt
European Patent Office
Office européen des brevets

(11) Publication number: **0 438 123 B1**

# (12) EUROPEAN PATENT SPECIFICATION

(45) Date of publication of patent specification: **13.09.95**

(51) Int. Cl.[6]: **C08F 2/46**, G03F 7/029

(21) Application number: **91100422.4**

(22) Date of filing: **15.01.91**

The file contains technical information submitted after the application was filed and not included in this specification

## (54) Near infrared polymerization initiator.

(30) Priority: **16.01.90 JP 6961/90**

(43) Date of publication of application:
**24.07.91 Bulletin 91/30**

(45) Publication of the grant of the patent:
**13.09.95 Bulletin 95/37**

(84) Designated Contracting States:
**CH DE FR GB LI NL**

(56) References cited:
**EP-A- 0 223 587**
**DE-A- 3 907 666**

**PATENT ABSTRACTS OF JAPAN, vol. 13, no. 185 (P-865)[3533], 2nd May 1989; & JP-A-1 13 142 (FUJI PHOTO FILM CO., LTD) 18-01-1989**

**Chemical Abstracts 111(26):244365Z & JP-A-01013142 (FUJI) 18-01-89.**

**Chemical Abstracts 110(16):145036R & JP-A-63208036 (CANON KK) 29-08-88.**

(73) Proprietor: **SHOWA DENKO KABUSHIKI KAISHA**
**13-9, Shiba Daimon 1-chome**
**Minato-ku, Tokyo (JP)**

(72) Inventor: **Murofushi, Katsumi, c/o Showa Denko K.K.**
**Kagakuhin Kenkyusho,**
**5-1, Ohgimachi**
**Kawasaki-ku,**
**Kawasaki-shi,**
**Kanagawa (JP)**
Inventor: **Hosoda, Yoshikazu, c/o Showa Denko K.K.**
**Kagakuhin Kenkyusho,**
**5-1, Ohgimachi**
**Kawasaki-ku,**
**Kawasaki-shi,**
**Kanagawa (JP)**

(74) Representative: **Strehl Schübel-Hopf Groening & Partner**
**Maximilianstrasse 54**
**D-80538 München (DE)**

**EP 0 438 123 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

BACKGROUND OF THE INVENTION

(1) Field of the Invention

The present invention relates to a polymerization initiator capable of initiating polymerization of at least one ethylenically unsaturated polymerizable monomer or oligomer with near infrared rays at a high sensitivity.

(2) Description of the Related Art

Photopolymerization is widely utilized in various fields; for example, for curing a coating film, forming a planographic printing plate, a resin letterpress printing plate and a printed circuit board, preparing a photoresist and a photomask, and making a black-and-white or color transfer sheet and a coloring sheet. Furthermore, a photopolymerizable composition is used in the field of the dentistry. In each case, however, photopolymerization is effected with ultraviolet rays or visible rays, and a polymerization by near infrared rays has not been developed.

In general, the photopolymerizable composition comprises an ethylenically unsaturated compound and a photopolymerization initiator (see, for example, Japanese Unexamined Patent Publication No. 59-138203, Japanese Unexamined Patent Publication No. 63-162769 and Japanese Unexamined Patent Publication No. 64-72150). Japanese Unexamined Patent Publication No. 63-162769 discloses a photopolymerizable composition in which a vinyl compound is cured in the presence of an amine such as N,N-dimethylaniline by using an $\alpha$-ketocarbonyl compound as the photopolymerization initiator under irradiation with ultraviolet rays and visible rays, and such photopolymerizable compositions are used as a tooth filler and a tooth sealant, for the production of a tooth crown and an artificial tooth bridge, and for the production of artificial teeth (see, for example, Japanese Unexamined Patent Publication No. 63-99858, Japanese Unexamined Patent Publication No. 63-189144 and Japanese Unexamined Patent Publication No. 63-203151). Furthermore, serious attempts have been made to develop an ultraviolet ray-curable ink as a photopolymerizable composition (see, for example, Japanese Unexamined Patent Publication No. 01-229084, Japanese Unexamined Patent Publication No. 01-271469 and Japanese Unexamined Patent Publication No. 02-22370).

Nevertheless, since visible rays are used for these photopolymerizable compositions, the light transmission is adversely affected by the hue of the composition or the filler, and the degree of curing is changed according to the hue or the amount added of the filler.

DE-OS-39 07 666 A1 relates to a photopolymerisation initiator composition sensitive to visible light of not less than 400 nm. The photopolymerisation initiator consists of a salt of an organic, cationic dye with an organic, anionic boron compound or of a combination of an organic, cationic dye and a salt of an organic, anionic boron compound and a sensitizer.

SUMMARY OF THE INVENTION

Therefore, a primary object of the present invention is to provide a polymerization initiator capable of initiating a polymerization at a high sensitivity with near infrared rays, which are not influenced by the hue of the photopolymerizable composition or the filler.

To solve this problem, investigations were made into a photopolymerization initiator comprising a specific near infrared ray-absorbing cationic dye and a boron-containing sensitizer and/or an organic peroxide in combination, and as a result, it was found that a spectrally sensitized polymerization initiator capable of initiating polymerization at a high sensitivity with near infrared rays can be obtained. The present invention is based on this finding.

More specifically, in accordance with the present invention, there is provided a near infrared polymerization initiator composition comprising a cationic dye showing absorptions in the near infrared region of at least 700 nm, which is represented by the following general formula (1):

$D^{+} \cdot A^{-}$ (1)

wherein $D^{+}$ represents a cationic dyestuff having absorptions in the near infrared region, and
$A^{-}$ represents an anion selected from borate anions represented by the following general formula (3);

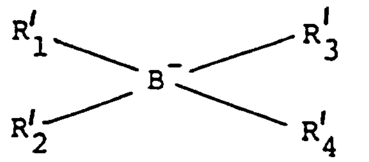

(3)

wherein R'$_1$, R'$_2$, R'$_3$ and R'$_4$ independently represent an alkyl, aryl, alkaryl, allyl, aralkyl, alkenyl, alkynyl, alicyclic or saturated or unsaturated heterocyclic group, with the proviso that at least one of R'$_1$, R'$_2$, R'$_3$ and R'$_4$ represents an alkyl group having 1 to 8 carbon atoms,
and at least one member selected from the group consisting of boron-containing sensitizers represented by the following general formula (2):

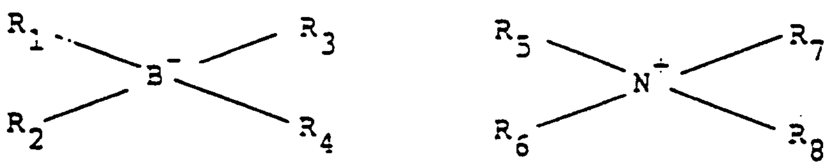

(2)

wherein $R_1$, $R_2$, $R_3$ and $R_4$ independently represent an alkyl, aryl, alkaryl, allyl, aralkyl, alkenyl, alkynyl, alicyclic, or saturated or unsaturated heterocyclic group, with the proviso that at least one of $R_1$, $R_2$, $R_3$ and $R_4$ represents an alkyl group having 1 to 8 carbon atoms, and $R_5$, $R_6$, $R_7$ and $R_8$ independently represent a hydrogen atom or an alkyl, aryl, allyl, alkaryl, aralkyl, alkenyl, alkynyl, alicyclic or saturated or unsaturated heterocyclic group.

DESCRIPTION OF THE PREFERRED EMBODIMENTS

The polymerization initiator of the present invention is capable of initiating polymerization at a high sensitivity with near infrared rays having a wavelength of at least 700 nm. A photopolymerizable composition that can be polymerized with near infrared rays can be obtained by adding the near infrared photopolymerization initiator to a free-radical addition-polymerizable or crosslinkable compound, or a mixture of this compound with an organic filler, an inorganic filler or a composite filler thereof or with a colorant such as a coloring dye or a pigment.

As the borate anion, triphenylbutyl borate anion and trianisylbutyl borate anion are especially preferable. Examples of the near infrared ray-absorbing cationic dye used in the present invention are shown in Table 1.

Table 1

| Dye No. | Structure | R | Ar | λ max (TMPT) |
|---|---|---|---|---|
| 1 | 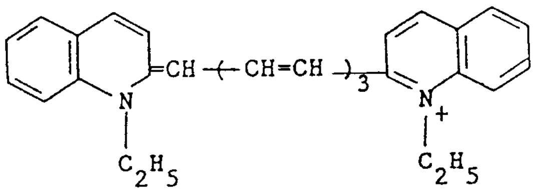 $Ph_3B^- \cdot n\text{-}C_4H_9$ | | | 820nm |
| 2 | 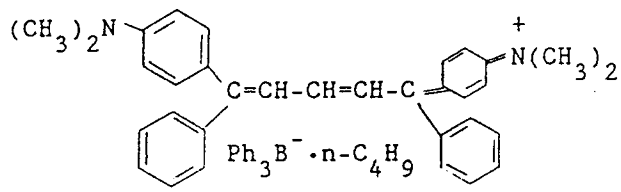 $Ph_3B^- \cdot n\text{-}C_4H_9$ | | | 830nm |
| 3-A | 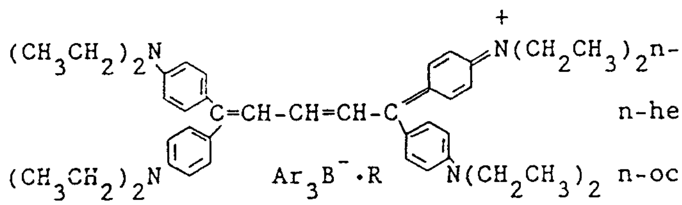 $Ar_3B^- \cdot R$ | n-butyl | phenyl | 822nm |
| 3-B | | n-hexyl | anisyl | 822nm |
| 3-C | | n-octyl | phenyl | 822nm |
| 4 | 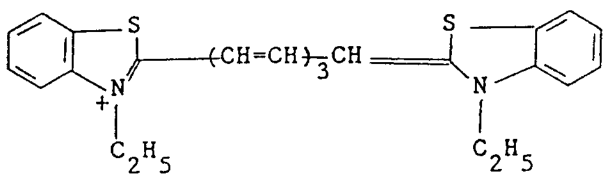 $Ph_3B^- \cdot n\text{-}C_4H_9$ | | | 768nm |
| -A | 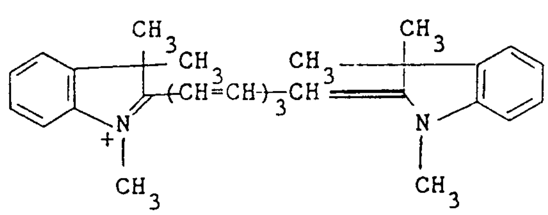 $Ar_3B^- \cdot R$ | n-butyl | phenyl | 748nm |
| 5-B | | n-hexyl | anisyl | 748nm |
| -C | | n-octyl | phenyl | 748nm |

Table 1 (continued)

| Dye No. | Structure | R | Ar | λ max (TMPT) |
|---|---|---|---|---|
| 6-A | 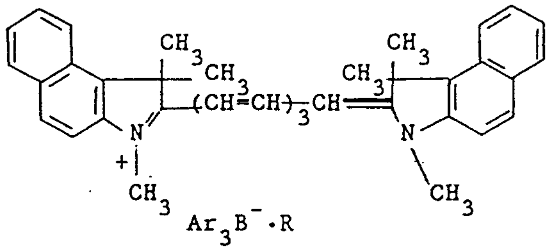 $Ar_3B^- \cdot R$ | n-butyl | phenyl | 785nm |
| 6-B | | n-hexyl | anisyl | 785nm |
| 6-C | | n-octyl | phenyl | 785nm |
| 7-A | 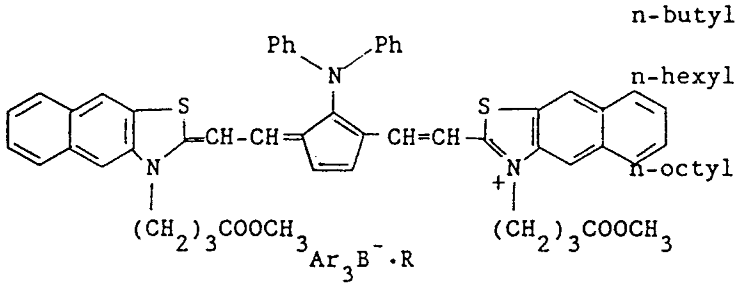 $Ar_3B^- \cdot R$ | n-butyl | phenyl | 828nm |
| 7-B | | n-hexyl | anisyl | 828nm |
| 7-C | | n-octyl | phenyl | 828nm |
| 8 | 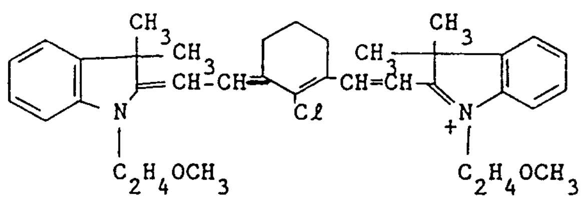 $Ph_3B^- \cdot n\text{-}C_4H_9$ | | | 787nm |
| 9 | 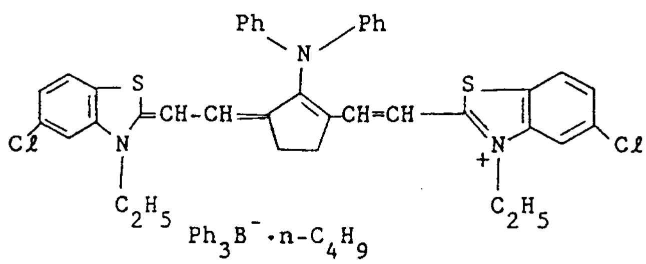 $Ph_3B^- \cdot n\text{-}C_4H_9$ | | | 819nm |
| 10 | 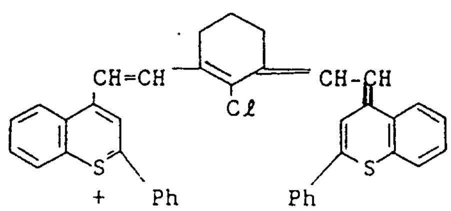 $Ph_3B^- \cdot n\text{-}C_4H_9$ | | | 1080nm |

Note

λ: absorption wavelength

TMPT: trimethylolpropane trimethacrylate

Ph: phenyl group

Preferably, these dyes are used in combination with an oxygen scavenger capable of absorbing oxygen in the free radical chain transfer process and a chain transfer agent acting as an active hydrogen donor. As examples of the oxygen scavenger, there can be mentioned, for example, phosphines, phosphites, phosphonates, stannous salts and other compounds that can be easily oxidized by oxygen. As the chain transfer agent, there can be mentioned, for example, N-phenylglycine, N-substituted N-phenylglycines such as methacryloxy-β-hydroxypropyl-N-phenylglycine, trimethylbarbituric acid, 2-mercaptobenzoxazole, 2-mercaptobenzothiazole, and N,N-dialkylanilines. Examples of the N,N-dialkylaniline are those in which at least one of ortho-, meta- and para-positions is substituted with an alkyl group, a phenyl group, an acetyl group, an ethoxycarbonyl group, a carbonyl group, a carboxylate group, a silyl group, an alkoxy group, a phenoxy group, an acetyloxy group, a hydroxyl group or a halogen atom. An N,N-dialkylaniline having the ortho-position substituted with an alkyl group is especially preferably used. For example, there can be mentioned 2,6-diisopropyl-N,N-dimethylaniline, 2,6-diethyl-N,N-dimethylaniline, N,N,2,4,6-pentamethylaniline and p-t-butyl-N,N-dimethylaniline.

The boron-containing sensitizer used in the present invention is a quaternary ammonium-borate complex represented by the general formula (2). As preferable examples, there can be mentioned tetramethylammonium n-butyltriphenyl borate, tetramethylammonium n-butyltrianisyl borate, tetramethylammonium n-octyltriphenyl borate, tetramethylammonium n-octyltrianisyl borate, tetraethylammonium n-butyltriphenyl borate, tetraethylammonium n-butyltrianisyl borate, trimethylhydrogenammonium n-butyltriphenyl borate, triethylhydrogenammonium n-butyltriphenyl borate, tetrahydrogenammonium n-butyltriphenyl borate, tetramethylammonium tetrabutyl borate and tetraethylammonium tetrabutyl borate.

Any of organic peroxides customarily used can be used as the organic peroxide. For example, there can be mentioned diacyl peroxides such as diacetyl peroxide,

The free-radical addition polymerizable or crosslinkable compound to which the polymerization initiator of the present invention can be applied includes, especially acrylic acid and methacrylic acid esters of monohydric alcohols and polyhydric alcohols, and 4-(meth)acryloyloxyl group-containing aromatic polycarboxylic acids and anhydrides thereof. So-called urethane acrylate and methacrylate are included in the above-mentioned esters. Furthermore,
2,2-bis[4-(3-methacryloxy-2-hydropoxy)-phenyl]propane,
which is a reaction product known from U. S. Patent No. 3,066,112,
di(methacryloxyethyl)trimethylhexamethylenediurethane,
2,2-bis(4-methacryloxypolyethoxyphenyl)propane,
tetramethylolmethane trimethacrylate,
tetramethylolmethane tetramethacrylate,
dipentaerythritolhexaacrylate,
dipentaerythritolhexamethacrylate,
4-(meth)acryloyloxymethoxycarbonylphthalic acid, an anhydride thereof,
4-(meth)acryloyloxyethoxycarbonylphthalic acid and an anhydride thereof are meant.

The filler that can be used in combination with the above-mentioned ethylenically unsaturated compound includes organic fillers, inorganic fillers and composite fillers thereof. A fine pulverization product of a polymer of an ethylenically unsaturated compound as mentioned above can be used as the organic filler. As the inorganic filler, there can be mentioned powders of silica, silica-alumina, alumina, quartz, glass, calcium carbonate, kaolin, talc, mica, aluminum sulfate, barium sulfate, calcium sulfate, titanium oxide and calcium phosphate, and fillers formed by coating the surfaces of these powders with polyfunctional (meth)-acrylate monomers or silane coupling agents. As the composite filler, there can be mentioned a product obtained by mixing an inorganic filler as mentioned above with an ethylenically unsaturated compound as mentioned above, polymerizing and curing the mixture and finely pulverizing the formed polymer.

Not only commercially available coloring dyes and pigments but also known dyes and pigments disclosed in various literature references (for example, "Handbook of Dyes" compiled by the Association of Organic Synthetic Chemistry and published in 1970 and "Newest Pigment Handbook" compiled by the Japanese Pigment Technical Association and published in 1976) can be used as the colorant in the present

invention.

Preferably, the near infrared photopolymerization initiator of the present invention contains the near infrared ray-absorbing cationic dye in an amount of 0.01 to 10% by weight, especially 0.1 to 5% by weight, based on the ethylenically unsaturated compound, and the boron-containing sensitizer and/or the organic peroxide is contained in an amount of 0.01 to 10% by weight, especially 0.1 to 5% by weight, per % by weight of the near infrared ray-absorbing cationic dye. Furthermore, an oxygen scavenger and a chain transfer agent can be added in amounts similar to the amount of the near infrared ray-absorbing cationic dye.

The photopolymerization initiator of the present invention is utilized in the fields where photopolymerization is conducted, for example, for photography, screen printing, sheet printing, planography, letterpress printing and metal surface processing, for the preparation of inks and printed circuit boards, for the formation of photoresists, photomasks, black-and-white and color transfer sheets and coloring sheets, for the production of toners for copying machines and encapsulated toners for copying machines, for the curing of paints, adhesives and unsaturated polyesters, for crosslinking of rubbers, and for the modification and crosslinking of polyolefins. A composition comprising this photopolymerization initiator, an ethylenically unsaturated compound, and a leuco dye or a coloring dye having an absorption in the visible region can be used for the formation of a black-and-white or color transfer sheet or a coloring sheet. The composition can be used when enclosed in microcapsules. Furthermore, the photopolymerization initiator of the present invention can be used for a dental filling composition for a denture or dental prosthesis, a dental covering or adhesive composition, and other dental treatment compositions.

A specific example of the application to a printing ink will now be described. A monomer or prepolymer having an ethylenically unsaturated group, which is usually used as the active vehicle, is kneaded with the near infrared photopolymerization initiator of the present invention and a pigment and the obtained near infrared ray-curable ink is printed to a thickness of 5 μm on an aluminum foil sheet used for packaging cosmetics and foods. Then, the coated aluminum foil sheet is irradiated with rays from an infrared ray irradiation apparatus, whereby the ink is dry-fixed to the aluminum foil sheet having no permeability and no drying property.

As an example of the application to a dental composition, there can be mentioned a treatment of a decayed portion of a molar tooth or front tooth of a patient. More specifically, the decayed portion is removed by a dental drill and the tooth is treated with an etching solution, a dental composition comprising the near infrared polymerization initiator is filled in the cavity, and the composition is cured by irradiation with near infrared rays by using a near infrared ray irradiation apparatus, whereby the treatment is accomplished.

According to the present invention, there is provided a polymerization initiator comprising a near infrared ray-absorbing cationic dye and a boron-containing sensitizer and/or an organic peroxide, which is capable of initiating polymerization at a high sensitivity with near infrared rays, not influenced by the hue of a photopolymerizable composition or a filler.

The present invention will now be described in detail with reference to the following examples that by no means limit the scope of the invention.

Examples 1 through 6

A pasty mixture comprising 4 g of 2,2'-bis[4-(3-methacryloxy-2-hydroxypropoxy)phenyl] propane, 2 g of trimethylolpropane trimethacrylate, 1 g of triethylene glycol dimethacrylate, 3 g of diethylene glycol dimethacrylate, 30 g of fine silica (particle size smaller than 10 μm; average particle size of 5 μm), a near infrared ray-absorbing cationic dye shown in Table 2, a boron-containing sensitizer shown in Table 2 and 0.04 g of N,N,2,4,6-pentamethylaniline was filled in a stainless steel mold (having an inner diameter of 6 mm and a height of 8 mm) and the surface of the filled paste was covered with a polyester film to form a sample.

Examples 7 through 9

A pasty mixture comprising 4 g of 2,2-di(methacryloxy)trimethylhexamethylene diurethane, 2 g of trimethylolpropane triacrylate, 1 g of triethylene glycol dimethacrylate, 3 g of diethylene glycol dimethacrylate, 1 g of lithium aluminum silicate (particle size smaller than 10 μm; average particle size of 5 μm), 29 g of aluminum oxide, a near infrared ray-absorbing cationic dye shown in Table 2, a boron-containing sensitizer shown in Table 2 and 0.04 g of N,N,2,4,6-pentamethylaniline was filled in a stainless steel mold (having an inner diameter of 6 mm and a height of 8 mm), and the surface of the filled paste was

covered with a polyester film to form a sample.

Examples 10 and 11

A mixture comprising 6 g of trimethylolpropane trimethacrylate, 4 g of triethylene glycol dimethacrylate, a near infrared ray-absorbing cationic dye shown in Table 2, a boron-containing sensitizer shown in Table 2, 0.04 g of N,N,2,4,6-pentamethylaniline and a colorant (supplied by Orient Kagaku Kogyo) shown in Table 2 was filled in a stainless steel mold (having an inner diameter of 6 mm and a height of 8 mm), and the surface of the filled mixture was covered with a polyester film to form a sample.

Examples 12 and 13

A mixture comprising 6 g of trimethylolpropane trimethacrylate, 4 g of triethylene glycol dimethacrylate, an infrared ray-absorbing cationic dye shown in Table 2, a boron-containing sensitizer shown in Table 2, 0.03 g of N-phenylglycine and a colorant (supplied by Orient Kagaku Kogyo) shown in Table 2 was filled in a mold (having an inner diameter of 6 mm and a height of 8 mm), and the surface of the filled mixture was covered with a polyester film to form a sample.

Comparative Example 1

By using the same near infrared ray-absorbing cationic dye as used in Example 1, a sample was prepared in the same manner as described in Example 1 except that a boron-containing sensitizer was not used, as shown in Table 2.

Comparative Example 2

By using dye 11 (comparative), a sample was prepared in the same manner as described in Examples 1-6 except that a boron-containing sensitizer was not used, as shown in Table 2.

Comparative Example 3

A sample was prepared in the same manner as described in Example 1 except that camphorquinone and hydroquinone monomethyl ether, heretofore used for a visible ray polymerization type resin, were used instead of the near infrared-absorbing cationic dye and boron-containing sensitizer used in Example 1, as shown in Table 2.

**Table 2**

| | Photopolymerization Initiator (Dye No. in Table 1) | Amount (% by weight) |
|---|---|---|
| Example 1 | dye 5A<br>TEAPB | 0.1<br>0.01 |
| Example 2 | dye 5A<br>TEAPB | 0.1<br>0.3 |
| Example 3 | dye 5A<br>TEAPB | 0.1<br>0.5 |
| Example 4 | dye 3A<br>TMAPB | 0.1<br>0.3 |
| Example 5 | dye 5B<br>TMAPB | 0.1<br>0.3 |
| Example 6 | dye 6C<br>TMAPB | 0.1<br>0.3 |
| Example 7 | dye 3B<br>TMAAB | 0.1<br>0.3 |
| Example 8 | dye 6C<br>TMAAB | 0.1<br>0.3 |
| Example 9 | dye 7A<br>TMHPB | 0.1<br>0.3 |
| Example 10 | dye 3A<br>TMAPB<br>colorant SO Red 1 | 0.1<br>0.3<br>10.0 |

Table 2 (continued)

| | Photopolymerization Initiator (Dye No. in Table 1) | Amount (% by weight) |
|---|---|---|
| Example 11 | dye 7B<br>TMAPB<br>colorant SO Cyane 1 | 0.1<br>0.3<br>10.0 |
| Example 12 | dye 3A<br>TMAPB<br>colorant SO Red 1 | 0.1<br>0.3<br>10.0 |
| Example 13 | dye 7B<br>TMAPB<br>colorant SO Cyane 1 | 0.1<br>0.3<br>10.0 |
| Comparative Example 1 | dye 5A | 0.1 |
| Comparative Example 2 | dye 11 | 0.1 |
| Comparative Example 3 | camphorquinone<br>hydroquinone monomethyl ether | 0.1<br>0.02 |

Note

TMAPB: tetramethylammonium n-butyltriphenyl borate

TEAPB: tetraethylammonium n-butyltriphenyl borate

TMAAB: tetramethylammonium n-butyltrianisyl borate

TMHPB: tetramethylhydrogenammonium n-butyltriphenyl borate

Each of the samples obtained in the foregoing examples and comparative examples was irradiated with a semiconductor laser having a wavelength of 830 nm, at an intensity of 200 mW for 10 seconds, and then the irradiated samples were immersed in ethanol for 1 hour to remove the unpolymerized component. Thereafter, with respect to each of samples of Examples 1 through 13 and Comparative Examples 1 through 3, the polymerizability and hue were evaluated, and the results are shown in Table 3.

**Table 3**

| | Hue after irradiation | Polymerizability |
|---|---|---|
| Example 1 | milky white | O |
| Example 2 | milky white | O |
| Example 3 | milky white | O |
| Example 4 | milky white | O |
| Example 5 | milky white | O |
| Example 6 | milky white | O |
| Example 7 | milky white | O |
| Example 8 | milky white | O |
| Example 9 | milky white | O |
| Example 10 | red | O |
| Example 11 | blue | O |
| Example 12 | red | O |
| Example 13 | blue | O |
| Example 14 | red | O |
| Comparative Example 1 | milky white | Δ |
| Comparative Example 2 | blue | x |
| Comparative Example 3 | milky white | x |

Note

O: irradiated portion was completely polymerized

Δ: unpolymerized part remained in irradiated portion

x: irradiated portion was not polymerized

portion

x: irradiated portion was not polymerized

## Claims

1. A near infrared polymerization initiator composition comprising a cationic dye showing absorptions in the near infrared region of at least 700 nm, which is represented by the following general formula (1) :

$D^{+}.A^{-}$ (1)

wherein $D^{+}$ represents a cationic dyestuff having absorptions in the near infrared region, and
$A^{-}$ represents an anion selected from borate anions represented by the following general formula (3);

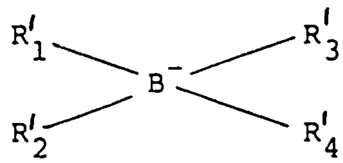

(3)

wherein $R'_1$, $R'_2$, $R'_3$ and $R'_4$ independently represent an alkyl, aryl, alkaryl, allyl, aralkyl, alkenyl, alkynyl, alicyclic or saturated or unsaturated heterocyclic group, with the proviso that at least one of $R'_1$, $R'_2$, $R'_3$ and $R'_4$ represents an alkyl group having 1 to 8 carbon atoms,
and at least one member selected from the group consisting of boron-containing sensitizers represented by the following general formula (2):

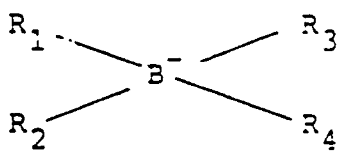

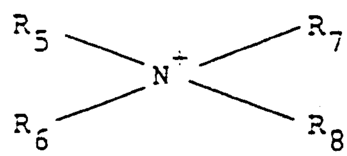

(2)

wherein $R_1$, $R_2$, $R_3$ and $R_4$ independently represent an alkyl, aryl, alkaryl, allyl, aralkyl, alkenyl, alkynyl, alicyclic, or saturated or unsaturated heterocyclic group, with the proviso that at least one of $R_1$, $R_2$, $R_3$ and $R_4$ represents an alkyl group having 1 to 8 carbon atoms, and $R_5$, $R_6$, $R_7$ and $R_8$ independently represent a hydrogen atom or an alkyl, aryl, allyl, alkaryl, aralkyl, alkenyl, alkynyl, alicyclic or saturated or unsaturated heterocyclic group.

2. An initiator composition as claimed in claim 1, wherein the cationic dyestuff is selected from cyanine, triarylmethane, aminium and diimonium dyestuffs.

3. An initiator composition as claimed in claim 2, wherein the borate anion is selected from triphenylbutyl borate anion and trianisylbutyl borate anion.

4. An initiator composition as claimed in any of the claims 1 to 3, wherein the near infrared ray-absorbing cationic dye is selected from the following complexes :

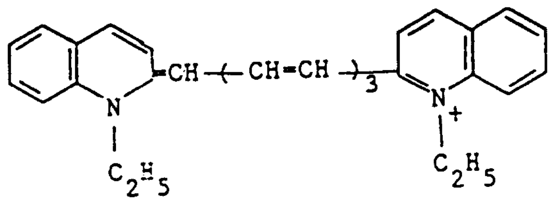

$Ph_3B^- \cdot n\text{-}C_4H_9$

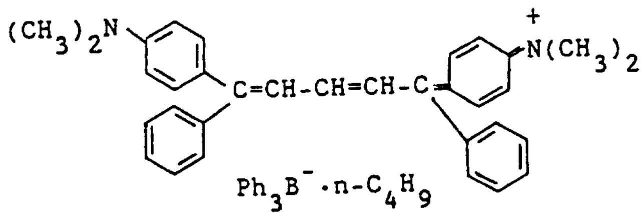

$Ph_3B^- \cdot n\text{-}C_4H_9$

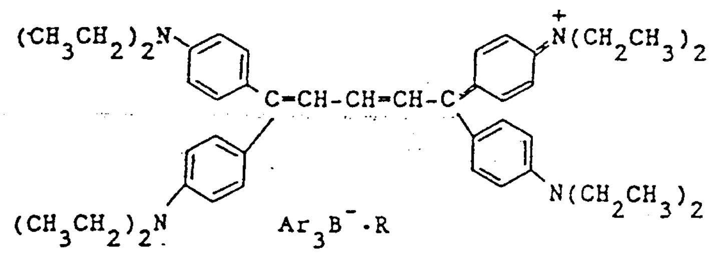

$Ar_3B^- \cdot R$

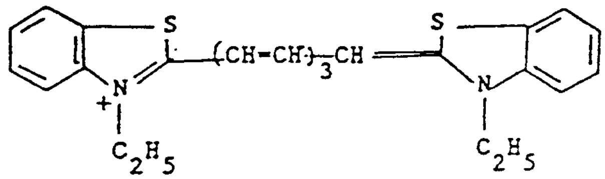

$Ph_3B^- \cdot n\text{-}C_4H_9$

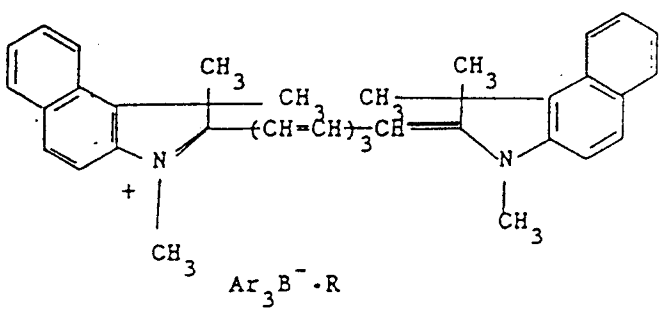

$Ar_3B^- \cdot R$

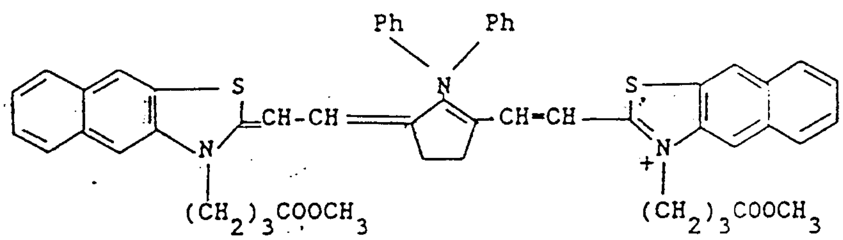

$Ar_3B^- \cdot R$

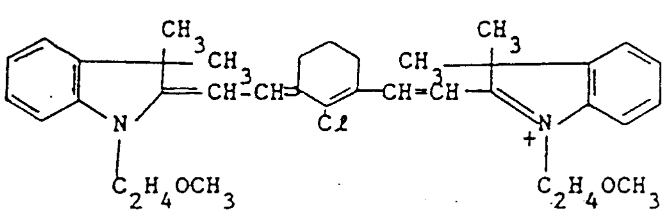

$Ph_3B^- \cdot n\text{-}C_4H_9$

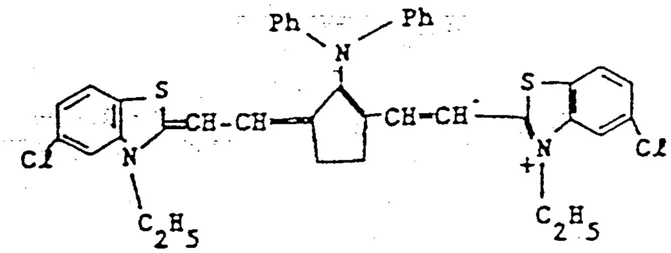

$Ph_3B^- \cdot n\text{-}C_4H_9$

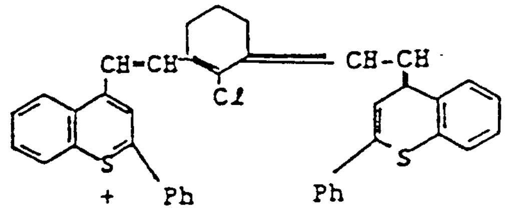

$Ph_3B^- \cdot n\text{-}C_4H_9$

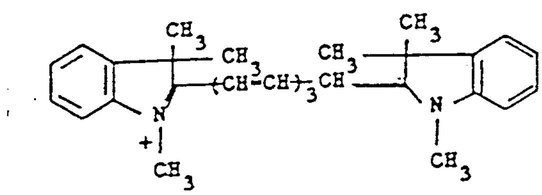

$Ar_3B^- \cdot R$

in the above formulae, Ph represents phenyl, R represents n-butyl, n-hexyl or n-octyl, and Ar represents phenyl or anisyl.

**5.** An initiator composition as claimed in any of the claims 1 to 4, wherein the near infrared ray-absorbing cationic dye is employed in combination with an oxygen scavenger and a chain transfer agent.

**6.** An initiator composition as claimed in claim 5, wherein the oxygen scavenger is selected from phosphines, phosphites, phosphonates, and stannous salts.

**7.** An initiator composition as claimed in claim 5, wherein the chain transfer agent is selected from N-phenylglycine, N-substituted N-phenylglycines, trimethylbarbituric acid, 2-mercaptobenzoxazole, 2-mercaptobenzothiazole, and N,N-dialkylanilines.

**8.** An initiator composition as claimed in any of the claims 1 to 7, wherein the boron-containing sensitizer is selected from tetramethylammonium n-butyltriphenyl borate, tetramethylammonium n-butyltrianisyl borate, tetramethylammonium n-octyltriphenyl borate, tetramethylammonium n-octyltrianisyl borate, tetraethylammonium n-butyltriphenyl borate, tetraethylammonium n-butyltrianisyl borate, trimethylhydrogenammonium n-butyltriphenyl borate, triethylhydrogenammonium n-butyltriphenyl borate, tetrahydrogenammonium n-butyltriphenyl borate, tetramethylammonium tetrabutyl borate and tetraethylammonium tetrabutyl borate.

**9.** An initiator composition as claimed in any of the claims 1 to 8, wherein the boron-containing sensitizer is contained in an amount of 0.01 to 10 % by weight per % by weight of the near infrared ray-absorbing cationic dye.

**10.** A process for the polymerization of an ethylenically unsaturated compound, wherein an initiator composition as claimed in any of the claims 1 to 9 is used.

**11.** The process as claimed in claim 10, wherein the ethylenically unsaturated compound is selected from acrylic acid and methacrylic acid esters of monohydric alcohols and polyhydric alcohols, and 4-(meth)-acryloyloxy group-containing aromatic polycarboxylic acids and anhydrides thereof.

**12.** A photopolymerizable composition for polymerization with near infrared rays of at least 700 nm comprising the near infrared initiator composition according to any of the claims 1 to 9, and a free-radical addition-polymerizable or crosslinkable compound or a mixture thereof with an organic filler, inorganic filler or composite filler and/or a colorant.

**13.** A composition as claimed in claim 12, wherein the free-radical addition-polymerizable or crosslinkable compound is an ethylenically unsaturated compound.

**14.** A composition as claimed in claim 12 or 13, wherein the near infrared ray-absorbing cationic dye is contained in an amount of 0.01 to 10 % by weight based on the ethylenically unsaturated compound.

**Patentansprüche**

**1.** Polymerisationsinitiator-Zusammensetzung für den nahen Infrarotbereich, die folgende Komponenten enthält: einen kationischen Farbstoff, der Absorptionen im nahen Infrarotbereich von mindestens 700 nm aufweist, und der durch die folgende allgemeine Formel (1) dargestellt ist:

$D^+ \bullet A^-$ (1),

worin $D^+$ einen kationischen Farbstoff mit Absorptionen im nahen Infrarotbereich darstellt, und $A^-$ ein Anion ist, das unter durch die folgende allgemeine Formel (3) dargestellten Boratanionen ausgewählt ist:

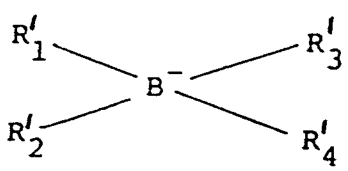 (3),

worin $R'_1$, $R'_2$, $R'_3$ und $R'_4$ jeweils eine Alkylgruppe, eine Arylgruppe, eine Alkarylgruppe, eine Allylgruppe, eine Aralkylgruppe, eine Alkenylgruppe, eine Alkinylgruppe, eine alicyclische Gruppe oder eine gesättigte oder ungesättigte heterocyclische Gruppe darstellen, mit der Maßgabe, daß mindestens eines der $R'_1$, $R'_2$, $R'_3$ und $R'_4$ eine Alkylgruppe mit 1 bis 8 Kohlenstoffatomen darstellt,
und mindestens ein Mitglied, das ausgewählt ist aus der Gruppe bestehend aus Bor enthaltenden Sensibilisatoren, die durch die folgende allgemeine Formel (2) dargestellt sind:

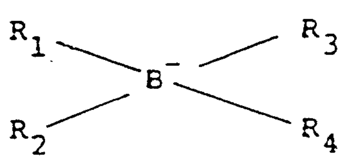 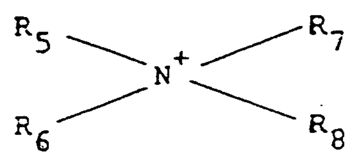 (2),

worin $R_1$, $R_2$, $R_3$ und $R_4$ jeweils unabhängig voneinander eine Alkylgruppe, eine Arylgruppe, eine Alkarylgruppe, eine Allylgruppe, eine Aralkylgruppe, eine Alkenylgruppe, eine Alkinylgruppe, eine alicyclische Gruppe oder eine gesättigte oder ungesättigte heterocyclische Gruppe darstellen, mit der Maßgabe, daß mindestens eines der $R_1$, $R_2$, $R_3$ und $R_4$ eine Alkylgruppe mit 1 bis 8 Kohlenstoffatomen darstellt, und $R_5$, $R_6$, $R_7$ und $R_8$ jeweils unabhängig ein Wasserstoffatom oder eine Alkylgruppe, eine Arylgruppe, eine Alkarylgruppe, eine Allylgruppe, eine Aralkylgruppe, eine Alkenylgruppe, eine Alkinylgruppe, eine alicyclische Gruppe oder eine gesättigte oder ungesättigte heterocyclische Gruppe darstellen.

**2.** Initiator-Zusammensetzung gemäß Anspruch 1, worin der kationische Farbstoff ausgewählt ist unter Cyanin, Triarylmethan, quartären Ammonium-Farbstoffen und Diimminium-Farbstoffen.

**3.** Initiator-Zusammensetzung gemäß Anspruch 2, worin das Borat-Anion ausgewählt ist unter dem Triphenylbutylborat-Anion und dem Trianisylbutylborat-Anion.

**4.** Initiator-Zusammensetzung gemäß einem der Ansprüche 1 bis 3, worin der im nahen Infrarotbereich absorbierende kationische Farbstoff ausgewählt ist unter den folgenden Komplexen:

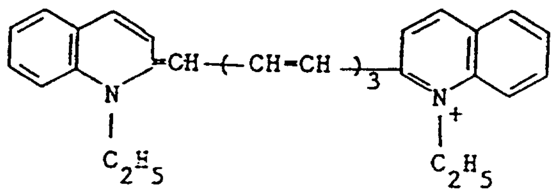

$Ph_3B^- \cdot n\text{-}C_4H_9$

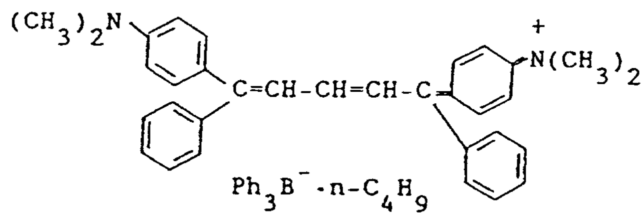

$Ph_3B^- \cdot n\text{-}C_4H_9$

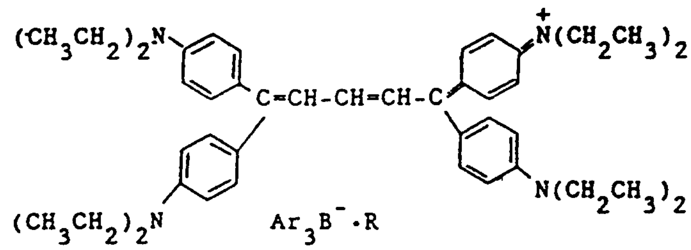

$Ar_3B^- \cdot R$

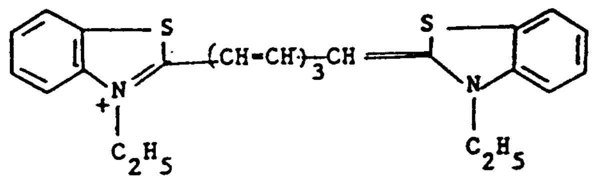

$Ph_3B^- \cdot n\text{-}C_4H_9$

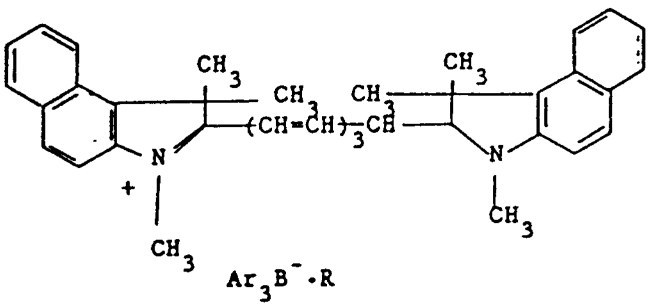

$Ar_3B^- \cdot R$

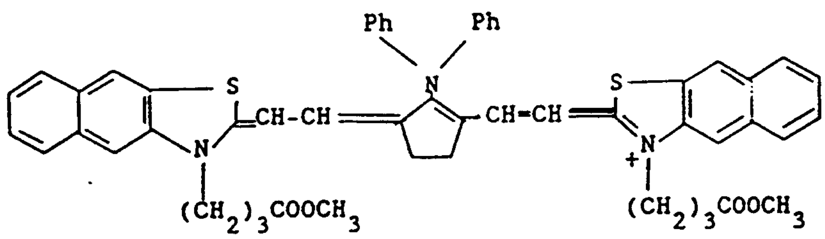

$Ar_3B^- \cdot R$

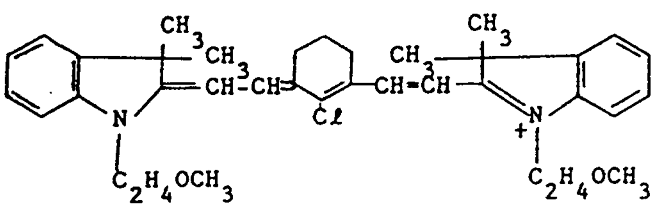

$Ph_3B^- \cdot n\text{-}C_4H_9$

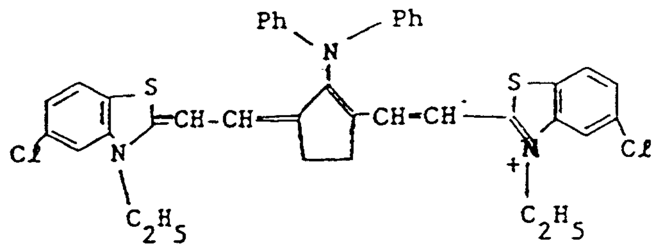

$Ph_3B^- \cdot n\text{-}C_4H_9$,

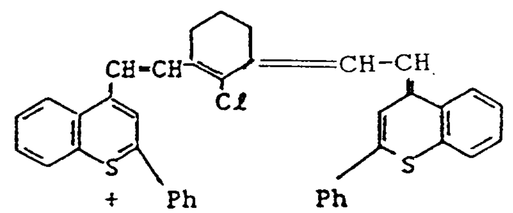

,

$Ph_3B^- \cdot n\text{-}C_4H_9$

worin in den obigen Formeln, Ph Phenyl darstellt, R n-Butyl, n-Hexyl oder n-Octyl darstellt, und Ar Phenyl oder Anisyl darstellt.

5. Initiator-Zusammensetzung gemäß einem der Ansprüche 1 bis 4, worin der im nahen Infrarotbereich absorbierende kationische Farbstoff in Verbindung mit einem Sauerstoffradikalfänger und einem Kettenübertragungsmittel eingesetzt wird.

6. Initiator-Zusammensetzung gemaß Anspruch 5, worin der Sauerstoffradikalfänger ausgewählt ist unter Phosphinen, Phosphiten, Phosphonaten und Zinn(II)-Salzen.

7. Initiator-Zusammensetzung gemäß Anspruch 5, worin das Kettenübertragungsmittel ausgewählt ist unter N-Phenylglycin, N-substituierten N-Phenylglycinen, Trimethylbarbitursäure, 2-Mercaptobenzoxazol, 2-Mercaptobenzothiazol und N,N-Dialkylanilinen.

8. Initiator-Zusammensetzung gemäß einem der Ansprüche 1 bis 7, worin der Bor enthaltende Sensibilisator ausgewählt ist unter
Tetramethylammonium-n-butyltriphenylborat,
Tetramethylammonlum-n-butyltrianisylborat,
Tetramethylammonium-n-octyltriphenylborat,
Tetramethylammonium-n-octyltrianisylborat,
Tetraethylammonium-n-butyltriphenylborat,
Tetraethylammonium-n-butyltrianisylborat,
Trimethylhydrogenammonium-n-butyltriphenylborat,
Triethylhydrogenammonium-n-butyltriphenylborat,
Tetrahydrogenammonium-n-butyltriphenylborat,
Tetramethylammonium-tetrabutylborat und
Tetraethylammonium-tetrabutylborat.

9. Initiator-Zusammensetzung gemäß einem der Ansprüche 1 bis 8, worin der Bor enthaltende Sensibilisator in einer Menge von 0,01 bis 10 Gew.-% bezogen auf 1 Gew.-% des im nahen Infrarotbereich absorbierenden kationischen Farbstoffs enthalten ist.

10. Verfahren zur Polymerisation einer ethylenisch ungesättigten Verbindung, worin eine Initiator-Zusammensetzung gemäß einem der Ansprüche 1 bis 9 verwendet wird.

**11.** Verfahren gemäß Anspruch 10, worin die ethylenisch ungesättigte Verbindung ausgewählt ist unter Acrylsäure- und Methacrylsäureestern von einwertigen und mehrwertigen Alkoholen, aromatischen Polycarbonsäuren, die eine 4-(Meth)acryloyloxy-Gruppe enthalten, und Anhydriden davon.

**12.** Photopolymerisierbare Zusammensetzung für die Polymerisation mit Strahlung im nahen Infrarotbereich von mindestens 700 nm, die die Initiator-Zusammensetzung für den nahen Infrarotbereich gemäß einem der Ansprüche 1 bis 9 und eine durch radikalische Additionspolymerisation polymerisierbare oder vernetzbare Verbindung oder eine Mischung davon mit einem organischen Füllstoff, einem anorganischen Füllstoff oder einem Verbund-Füllstoff davon und/oder einem Färbemittel enthält.

**13.** Zusammensetzung gemäß Anspruch 12, worin die durch radikalische Additionspolymerisation polymerisierbare oder vernetzbare Verbindung eine ethylenisch ungesättigte Verbindung ist.

**14.** Zusammensetzung gemäß Anspruch 12 oder 13, worin der im nahen Infrarotbereich absorbierende kationische Farbstoff in einer Menge von 0,01 bis 10 Gew.-% bezogen auf die ethylenisch ungesättigte Verbindung enthalten ist.

**Revendications**

**1.** Composition initiatrice de polymérisation presqu'infrarouge comprenant un colorant cationique présentant des absorptions dans la zone presqu'infrarouge d'au moins 700 nm, qui est représentée par la formule générale suivante (1):

$D^+ \cdot A^-$ (1)

où $D^+$ représente un colorant cationique présentant des absorptions dans la zone presqu'infrarouge, et $A^-$ représente un anion choisi parmi les anions de borate représentés par la formule générale suivante (3):

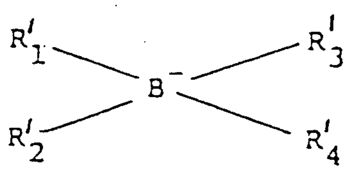

(3)

où $R'_1$, $R'_2$, $R'_3$ et $R'_4$ représentent, indépendamment, un groupe alcoyle, aryle, alkaryle, allyle, aralkyle, alkényle, alkynyle, alicyclique ou hétérocyclique saturé ou non-saturé, à la condition qu'au moins l'un parmi $R'_1$, $R'_2$, $R'_3$ et $R'_4$ représente un groupe alcoyle ayant de 1 à 8 atomes de carbone, et au moins un élément choisi parmi le groupe composé de sensibilisateurs à teneur en bore représentés par la formule générale suivante (2):

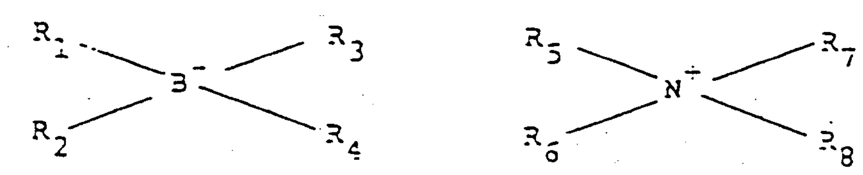

(2)

où $R'_1$, $R'_2$, $R'_3$ et $R'_4$ représentent, indépendamment, un groupe alcoyle, aryle, alkaryle, allyle, aralkyle, alkényle, alkynyle, alicyclique ou hétérocyclique saturé ou non-saturé, à la condition qu'au moins l'un parmi $R'_1$, $R'_2$, $R'_3$ et $R'_4$ représente un groupe alcoyle ayant de 1 à 8 atomes de carbone, et $R'_5$, $R'_6$, $R'_7$ et $R'_8$ représentent, indépendamment, un atome d'hydrogène ou un groupe alcoyle, aryle, allyle, alkaryle, aralkyle, alkényle, alkynyle, alicyclique ou hétérocyclique saturé ou non-saturé.

**2.** Composition initiatrice suivant la revendication 1, dans laquelle le colorant cationique est choisi parmi les colorants cyanés, triarylméthaniques, aminiques et diimoniques.

**3.** Composition initiatrice suivant la revendication 2, dans laquelle l'anion de borate est choisi parmi l'anion de borate de triphénylbutyle et l'anion de borate de trianisylbutyle.

**4.** Composition initiatrice suivant l'une ou l'autre des revendications 1 à 3, dans laquelle le colorant cationique absorbant les rayons presqu'infrarouges est choisi parmi les complexes suivants:

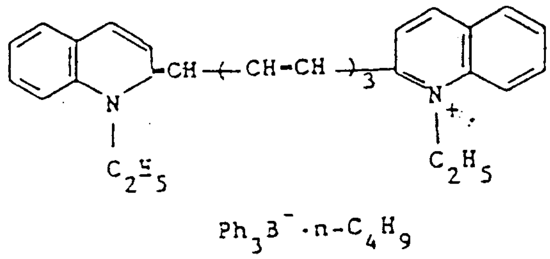

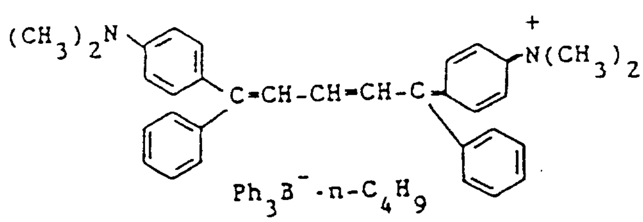

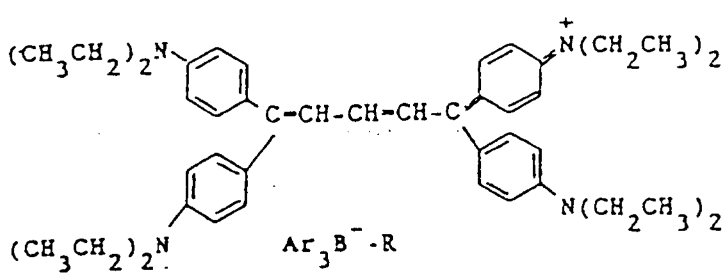

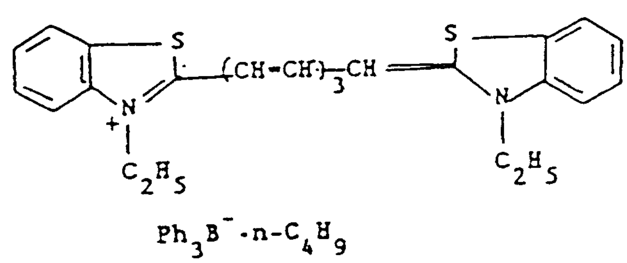

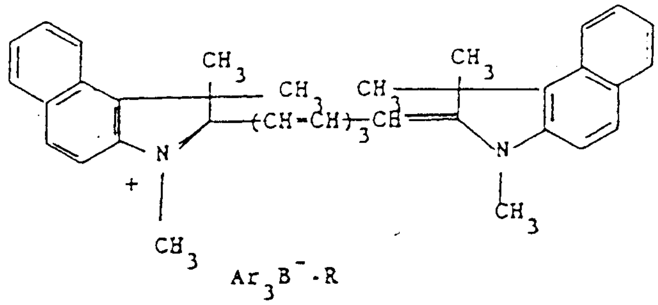

$Ar_3B^- \cdot R$

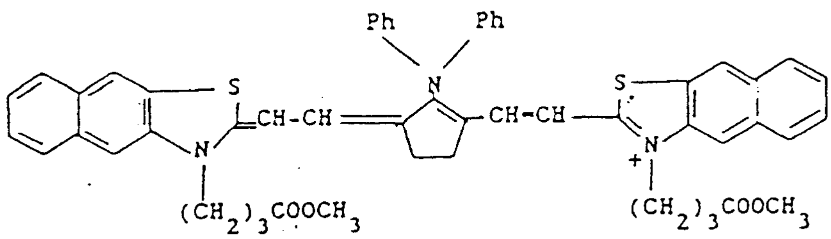

$Ar_3B^- \cdot R$

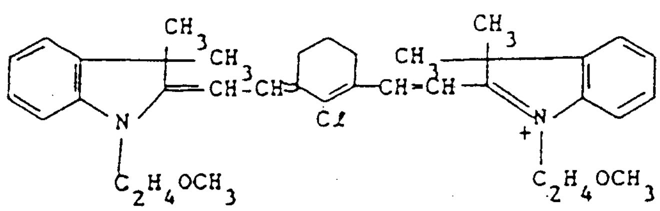

$Ph_3B^- \cdot n\text{-}C_4H_9$

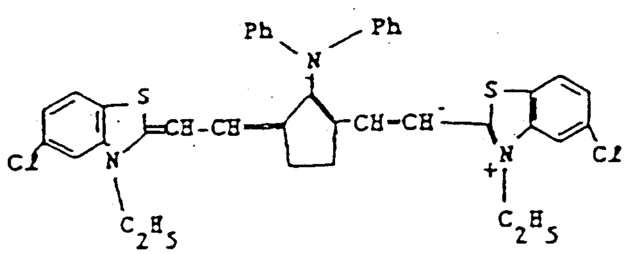

$Ph_3B^- \cdot n\text{-}C_4H_9$

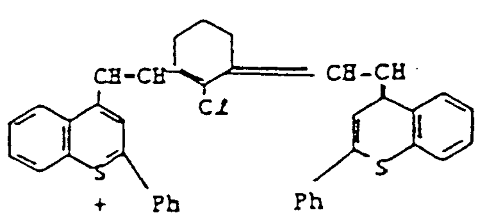

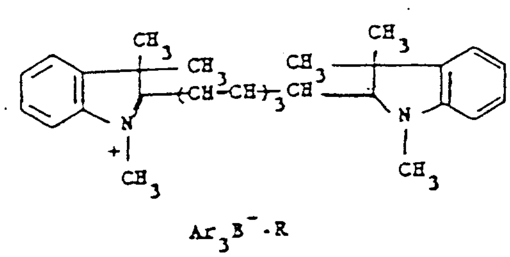

dans les formules ci-dessus, Ph représentant phényl, R représentant n-butyle, n-hexyle ou n-octyle, et Ar représentant phényle ou anisyle.

**5.** Composition initiatrice suivant l'une ou l'autre des revendications 1 à 4, dans laquelle le colorant cationique absorbant les rayons presqu'infrarouges est utilisé en combinaison avec un éliminateur d'oxygène et un agent de transfert de la chaîne.

**6.** Composition initiatrice suivant la revendication 5, dans laquelle l'éliminateur d'oxygène est choisi parmi les phosphines, les phosphites, les phosphonates et les sels stanneux.

**7.** Composition initiatrice suivant la revendication 5, dans laquelle l'agent de transfert de la chaîne est choisi parmi la N-phénylglycine, les N-phénylglycines à substitution de N, l'acide triméthylbarbiturique, le 2-mercaptobenzoxazole, le 2-mercaptobenzothiazole et les N,N-dialkylanilines.

**8.** Composition initiatrice suivant l'une ou l'autre des revendications 1 à 7, dans laquelle le sensibilisateur à teneur en bore est choisi parmi tétraméthylammonium-borate de n-butyltriphényle, tétraméthylammonium-borate de n-butyltrianisyle, tétraméthylammonium-borate de n-octyltriphényle, tétraméthylammonium-borate de n-octyltrianisyle, tétra-éthylammonium-borate de n-butyltriphényle, tétra-éthylammonium-borate de n-butyltrianisyle, triméthylhydrogène-ammonium-borate de n-butyltriphényle, triéthylhydrogène-ammonium-borate de n-butyltriphényle, tétrahydrogène-ammonium-borate de n-butyltriphényle, tétraméthylammonium-borate de tétrabutyle et tétra-éthylammonium-borate de tétrabutyle.

**9.** Composition initiatrice suivant l'une ou l'autre des revendications 1 à 8, dans laquelle le sensibilisateur à teneur en bore est contenu en une quantité de 0,01 à 10% en poids par % en poids du colorant cationique absorbant les rayons presqu'infrarouges.

**10.** Procédé de polymérisation d'un composé éthyléniquement non-saturé, dans lequel est utilisée une composition initiatrice suivant l'une ou l'autre des revendications 1 à 9.

**11.** Procédé suivant la revendication 10, dans lequel le composé éthyléniquement non-saturé et choisi parmi les esters de l'acide acrylique et de l'acide méthacrylique des alcools monovalents et des alcools polyvalents, et les acides polycarboxyliques aromatiques contenant un groupe 4-(méth)-acryloyloxy et les anhydrides de ceux-ci.

**12.** Composition photopolymérisable destinée à la polymérisation à l'aide de rayons presqu'infrarouges d'au moins 700 nm, comprenant la composition initiatrice suivant l'une ou l'autre des revendications 1 à 9 et un composé polymérisable ou réticulable par addition d'un radical libre ou un mélange de celui-ci avec une charge organique, une charge inorganique ou une charge composée et/ou un colorant.

**13.** Composition suivant la revendication 12, dans laquelle le compose polymérisable ou réticulable par addition d'un radical libre est un compose éthyléniquement non-saturé.

**14.** Composition suivant la revendication 12 ou 13, dans laquelle le colorant cationique absorbant les rayons presqu'infrarouges est contenu en une quantité de 0,01 à 10% en poids sur base du composé éthyléniquement non-saturé.